# EUROPEAN PATENT SPECIFICATION

(11) **EP 2 105 988 B1**
(45) Date of publication and mention of the grant of the patent: **21.09.2016**
(21) Application number: 09445008.7
(22) Date of filing: 18.03.2009
(51) Int. Cl.: H01P 3/08, H01P 11/00, H05K 1/18, H05K 3/36

(54) **Transmission line and a method for production of a transmission line**
Übertragungsleitung und Verfahren zur Herstellung einer Übertragungsleitung
Ligne de transmission et procédé pour la production d'une ligne de transmission

(30) Priority: 19.03.2008 SE 0800642
(43) Date of publication of application: 30.09.2009
(73) Proprietor: Intel Corporation, Santa Clara, CA 95054 (US)
(72) Inventor: Lindmark, Björn, 191 48 Sollentuna (SE)
(74) Representative: Goddar, Heinz J.

(56) References cited:
- WO-A-2007/036607
- DE-C- 935 014
- JP-A- 1 125 101
- JP-A- 2 113 702
- US-A- 3 192 492
- US-A- 3 496 492
- US-A- 3 904 997
- US-A- 4 254 383
- US-A1- 2002 080 086
- US-A1- 2002 130 739
- WENZHANG WANG ET AL: "Static analysis of millimeter wave transmission lines micromachined in silicon substrate" DIGEST OF THE ANTENNAS AND PROPAGATION SOCIETY INTERNATIONAL SYMPOSIUM. SEATTLE, WA., JUNE 19 - 24, 1994; [DIGEST OF THE ANTENNAS AND PROPAGATION SOCIETY INTERNATIONAL SYMPOSIUM], NEW YORK, IEEE, US, vol. 3, 20 June 1994 (1994-06-20), pages 1960-1963, XP010142433 ISBN: 978-0-7803-2009-3

## Description

### Field of the invention

The present invention concerns a transmission line according to the preamble of claim 1. Further, it concerns a method for production of a transmission line.

### Background art

The use of microstrip lines with air as the dielectric has been used in base station antennas since at least the mid-90s. The advantage is low loss and ease of manufacture in the sense that a flat ground plane can be used for the lines. The disadvantage of such lines is the necessary width, which for example at a 3 mm separation is 13 mm for a 50 ohms line. The absence of a dielectric, other than air, also means that the mutual coupling is rather high.

As another prior art in respect of the present invention US patent 5 652 557 could be mentioned. This patent discloses a transmission line consisting of a longitudinal groove in a dielectric material having longitudinal walls and bottom disposed with a metallisation film. In the groove, a conductor line is formed by a metal film.

However, the conductor of US 5 652 557 is manufactured by disposing a conductor film on a dielectric. Such a production method can be complex and expensive, yielding an expensive transmission line.

US 4,254,383 describes an inverted microstrip phase shifter. The phase shifter consists of a substrate having biasing circuitry connected to one side and a center conductor connected to its opposite side. The inverted microstrip configuration includes that the substrate side containing the center conductor is enclosed within a hollow case so as to form an rf transmission line.

WO 2007/036607 A1 describes various transmission line structures for antenna feed in base stations. One structure comprises a two-sided transmission line, where a symmetry axis is inside a dielectric plate. The dielectric plate belongs to a circuit board, which further comprises a centre conductor of the transmission line. The centre conductor is also two-sided; it comprises a first microstrip on the upper surface of the plate and a second microstrip on the lower surface of that plate. These microstrips are connected to each other by vias. Another configuration of a transmission line structure comprises two transmission lines. Each transmission line consists of a centre conductor, a shared ground conductor, and air as an intermediate material. The parallel centre conductors are located on a basic layer, each in an elongated space of its own. The transmission lines lead to power dividers, in which each line branches into two parts. Each of the structures can be used for feeding an array antenna.

US 3,904,997 describes a microwave transmission line, in which a conductor strip is supported on one side of a high-dielectric substrate body, the other side of which is not backed by a ground plane conductor. The side of the dielectric body with the conductor strip is faced toward and spaced a distance from the ground plane conductor. A channel is provided in the ground plane conductor, wherein the channel is an elongated passage of rectangular cross-section. The dielectric body is in contact with the conductive material of the ground plane conductor along two paths at the sides of the channel. The conductor strip is enclosed in the channel, between the side paths, spaced from the ground plane body.

DE 935 014 C describes asymmetric microstrip transmission lines which comprise a broad conducting strip and a narrow conducting strip, the strips being isolated from each other by an insulator arranged in between the strips. The broad strip can be bent around the narrow strip such that the broad strip has a U-type cross-section and the narrow strip is upright included within the sides of the "U".

US 2002/0080086 A1 describes an integrated feed system for an antenna which includes a circuit board, a feed network formed on the circuit board, and a plurality of feed elements electrically coupled with the feed network and projecting outwardly therefrom. Microstrips can be used as patch feed elements. The circuit board has one or more projecting edge parts for mounting the feed elements. An antenna having one or more reflector elements utilizes the integrated antenna feed system.

US 3,192,492 describes microwave phase shifters wherein phase shifting is achieved with a variable dielectric. A metallic hollow parallelepiped has its longitudinal sides removed. A metallic rod conductor is disposed between opposite faces of the parallelepiped. A member of the same size and shape as the hollow portion of the parallelepiped contains a pair of metallic electrically conducting sections forming a slot partially filled by a wedge shaped slotted dielectric. The slot is located to enable the conductor rod to fit therein when the member is slidably inserted into the hollow portion of the parallelepiped. Sliding the member transversely with respect to the rod varies the amount of dielectric inserted between inner and outer elongated conductors.

US 3,496,492 A describes a microwave strip-in-trough line. A shield casing is comprised of a metal block provided with a groove. The groove forms a narrow elongated chamber which receives an insulating plate and a strip-like conductor therein. The side walls of the of the shield casing extend relatively high above the strip conductor.

JP H02 0211 3702 A describes a microstrip line, where a thin shield conductor plate is recessed to form a groove. A dielectric base is formed on the bottom of the groove, and a strip conductor is formed on the base.

### Summary of the invention

It is an object of the present invention to propose a solution for or a reduction of the problems of prior art. A main object is consequently to propose a transmission line having beneficial electric properties and at the same time is both rational in construction and easy to employ.

According to the invention this is accomplished by a transmission line having the features of claim 1. Using a centre conductor comprising at least one conductor formed on a side of a printed circuit board (PCB) provides for a simple and relatively cheap construction. Another proposition could be to use a piece of metal as the centre conductor. However, compared to such a piece of metal, a PCB offers prospects of better dimensional accuracy, lower weight, and possibly also lower cost than sheet metal.

According to another aspect of the disclosure, one or more of the above objectives is achieved with a method for production of a transmission line. This is a straightforward method of production that is simple to employ.

Further advantageous embodiments are disclosed in the dependent claims.

### Brief description of the drawings

Embodiments exemplifying the invention will now be described, by means of the appended drawings, in which
Figs. 1a and 1b illustrate schematically a transmission line of the invention,
Figs. 2a and 2b illustrate schematically a case of attenuation properties for the transmission lines of figs. 1a and 1b,
Fig. 3 illustrates transmission lines according to the invention mounted on the back of an antenna reflector,
Figs. 4a-4c illustrate two transmission lines according to the invention, connected to each other with a conducting element, from different perspectives,
Fig. 5 illustrate a dielectric in an embodiment of the invention,
Fig. 6 illustrates the use of a cross connection between two separate transmission lines, and
Figs. 7a-7b illustrate the use of a plurality of transmission lines of the invention.

### Detailed description of the invention

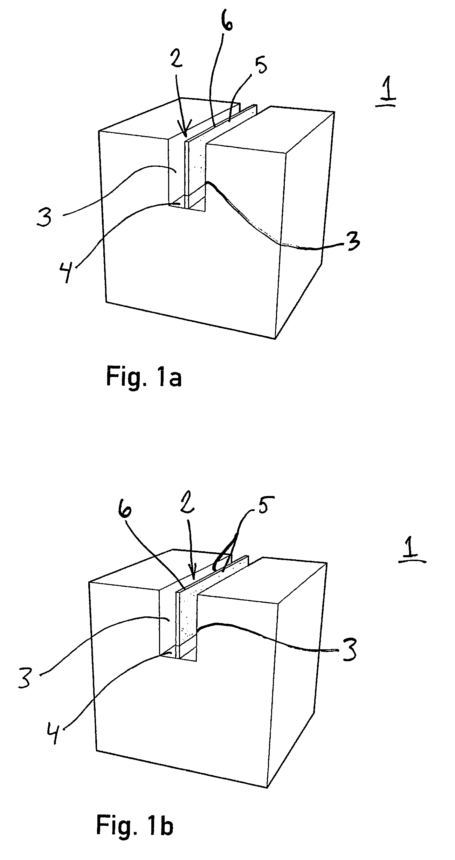

A conceptual embodiment of the invention is shown in fig. 1a. It is a transmission line 1 that comprises:
- a groove 2 defined by two parallel conducting walls 3 and a conducting floor 4 all electrically connected to each other, together forming a peripheral conductor of the transmission line, and
- a centre conductor 5, at least partly submersed in the groove 2, the centre conductor 5 being isolated from the conducting walls 3 and the conducting floor 4 of the groove 2. The centre conductor 5 comprises at least one conductor formed on a side of a printed circuit board 6. The transmission line 1 is working in near transverse electromagnetic mode (TEM-mode) or quasi TEM-mode. The small discrepancy from a full TEM-mode is due to the different permittivity of air and the dielectric material in the thin PCB dielectric surrounding the centre conductor.

Typically, such a conductor formed on a side of a printed circuit board would be a conducting strip formed on the printed circuit board. However, other conductors are in theory not ruled out; it is conceivable to have other types of conductors than strips formed on the printed circuit board.

The design of the transmission line as in fig.la ensures efficient use of the conducting strip area, since the field is distributed on both sides of the strip due to the surrounding walls and floor of the groove. This means a lower loss compared to a microstrip transmission line. At the same time the open configuration brought about by the groove provides for good accessibility of the line during assembly while still affording mechanical protection of the centre conductor. The production of such a transmission line could be configured to be easy and relatively cheap.

An alternative to the PCB would be to use a piece of sheet metal. However, compared to such a solution, the PCB may provide better dimensional accuracy, lower weight, and possibly also lower cost than such a piece of sheet metal.

In fig. 1b a transmission line is shown wherein the centre conductor 5 comprises two conductors on two sides of the printed circuit board 6, i.e. both sides of the PCB are used for the centre conductor. This solution provides for a slightly lower impedance over a frequency range from 0.50 -2.0 GHz according to simulations, see below.

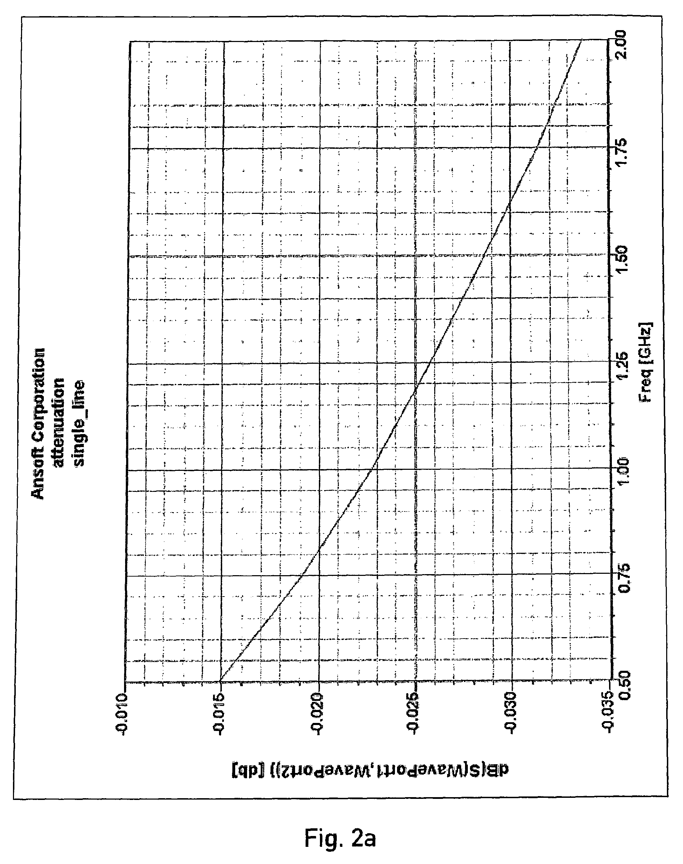

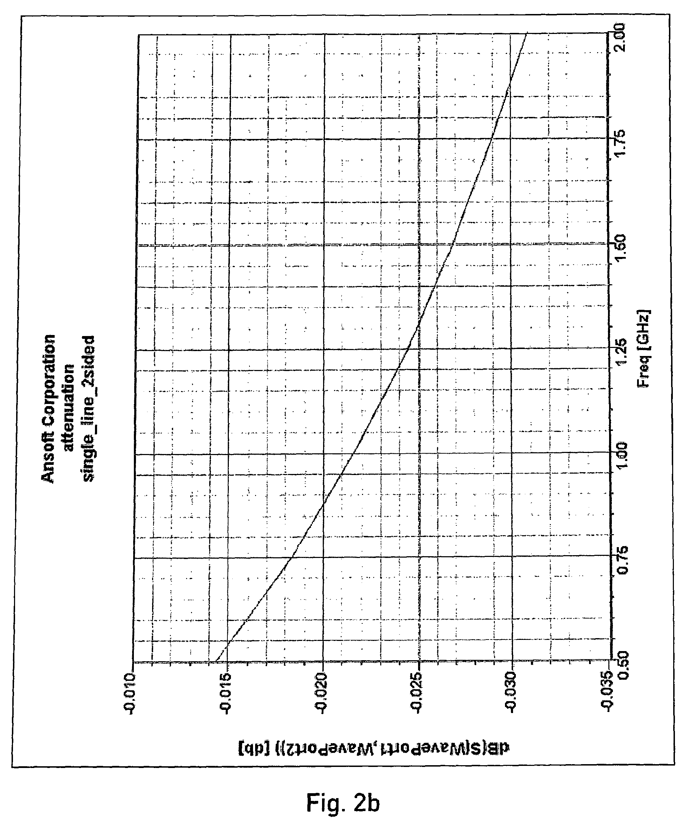

Simulations of the attenuation of the transmission lines in figs. 1a and 1b respectively are shown in figs. 2a and 2b. Fig. 2a corresponds to fig. 1a and fig. 2b corresponds to fig. 1b. Figs. 1a/2a are for a one-sided, 200 mm copper line on a 20 mil (0.508 mm) thick Rogers 4003 substrate. Figs. 1b/2b are for a two-sided, 200 mm copper line on a 20 mil (0.508 mm) thick Rogers 4003 substrate. For both cases, total width of the groove 2 was 8 mm (corresponding to the floor 4), depth was 15 mm (corresponding to the walls 3). Material of walls and floor was aluminium. Line width was 11 mm, line thickness was 35 µm. As can be seen, attenuation is a bit less for the two-sided case of figs. 1b/2b.

Returning to figs. 1a and 1b for awhile, the centre conductor 5 of the transmission line 1, could be formed on the printed circuit board 6 by etching. This means that a high dimensional precision of the centre conductor could be accomplished. Such precision could be attained using standard, and therefore cheap, etching equipment well known in the electronics industry.

In principle, the printed circuit board 6 of the transmission line 1 could be positioned in the groove 2 with its main surfaces perpendicular to the walls 3 of the groove 2. However, when the printed circuit board 6 of the transmission line 1 is positioned in the groove 2 with its main surfaces in parallel with the walls 3 of the groove 2, a more efficient use of the conducting strip area is achieved, resulting in a lower attenuation of the transmission line.

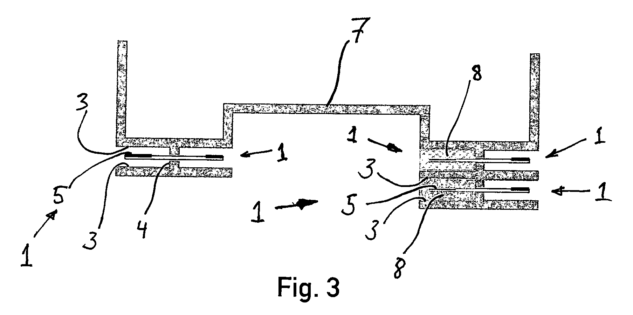

The walls 3 and the floor 4 of the transmission line 1 according to the invention could be constructed in many different ways. They could be separate parts that are joined together by suitable means or an integral part. Such separate parts or integral part could for instance be an aluminium profile, such as an aluminium extrusion. Also, as seen in fig. 3, at least a part of any of the walls 3 and the floor 4 defining the groove could also be a part of an antenna reflector 7. This enables a rational construction wherein e.g. the back of an antenna reflector can be reused as a part of the groove, thus providing a dual function. Fig. 3 illustrates in a side elevation view an antenna reflector having mounted at the back of it a plurality of transmission lines 1. Also shown in Fig. 3 is a slidable dielectric 8 positioned in a space between the centre conductor 5 and at least one of the parallel conducting walls 3. Due to the slidable dielectric, the impedance of a part of the transmission line could be controlled, for instance in order to vary/tune the phase of a signal on the transmission line. The dielectric could be slidable in a suitable direction. In fig. 3 that could be in the direction in or out of the paper. Alternatively it could be in a direction in or out of the groove, i.e. left or right in the figure.

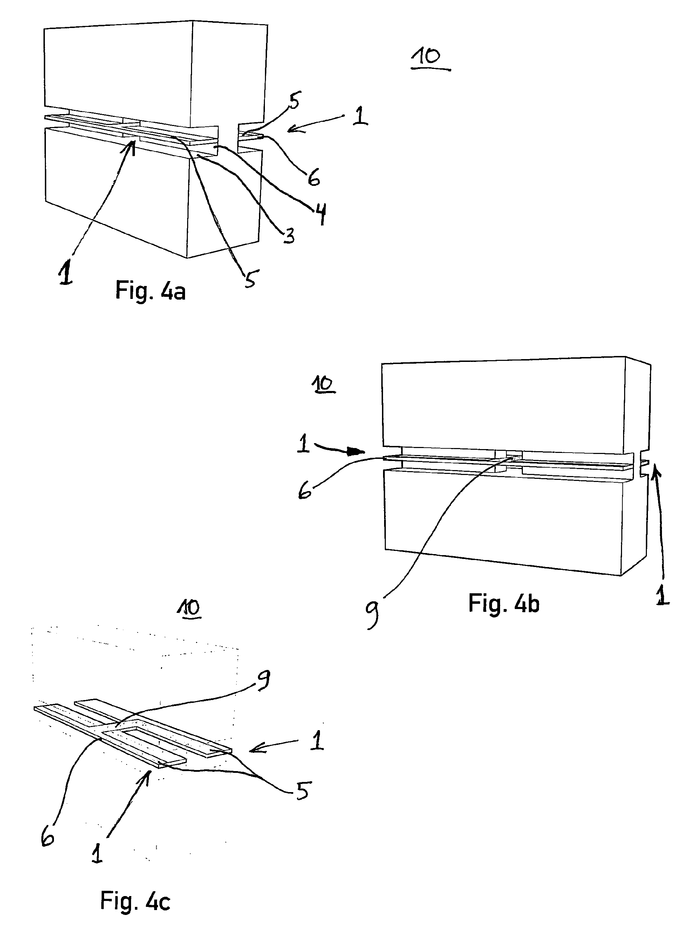

As figs. 4a-c show, a System 10 comprising a plurality of transmission lines 1 according to any of the previously described transmission lines of the invention could be formed, wherein at least two centre conductors 5 of the plurality of transmission lines are connected to each other with a conducting element 9 in order to provide for a dividing of a signal that can enter the system 10 on one of the plurality of transmission lines into at least one other transmission line. The conducting element 9 is shown in fig. 4a-c going through a port between the two grooves of the figure.

Figs. 4a-c all show the same system 10 from different angles and in the case of fig. 4c, also in some translucency in order to clarify the design and placement of a PCB 6 with its centre conductor 5 in the system.

In order to provide for a rational and economical production of such a system 10, at least two centre conductors could be formed on a same printed circuit board 6. That would yield at least two conductors using only one PCB, as can be seen in figs. 4a-c. The forming of at least two centre conductors on the same PCB also has the further benefit that the conducting element 9 between them could be a conductor formed on the printed circuit board 6. In that way, there would not be any requirements for the soldering of wires between the transmission lines.

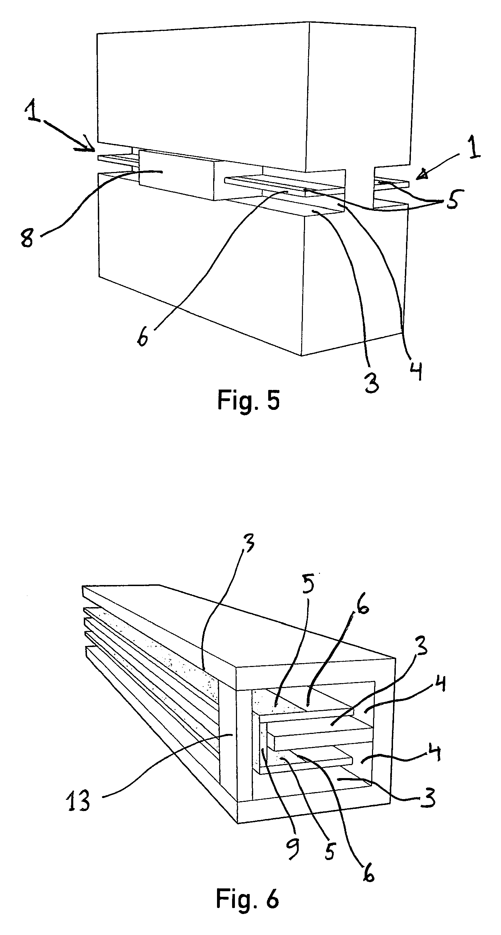

A figure similar to that of figures 4a-c is shown in figure 5 with the addition of a slidable dielectric 8. This is basically a three dimensional schematic view of the slidable dielectric of fig. 3, showing only two transmission lines 1 though.

For the case wherein at least two centre conductors in the system of the invention are on separate printed circuit boards 6, it would be beneficial if the conducting element 9 is running through one of the walls and the floor, that is either through one of the walls or through the floor, of the groove of at least one of the transmission lines, preferably both of the lines. This is shown in figure 6, where a cut out in the middle wall is effected in order to provide space for the conducting element 9. It should be noted that the walls and floors of the at least two transmission lines should share the same voltage potential, in order to avoid any differential modes. In particular, it is important to maintain the same potential of the walls in both transmission lines. It can be seen in fig. 6 that the two centre conductors 5 are connected with a conducting element 9. Further, in order to maintain the same potential of the walls in both transmission lines, a conductor 13 is provided connecting both (outer) walls 3.

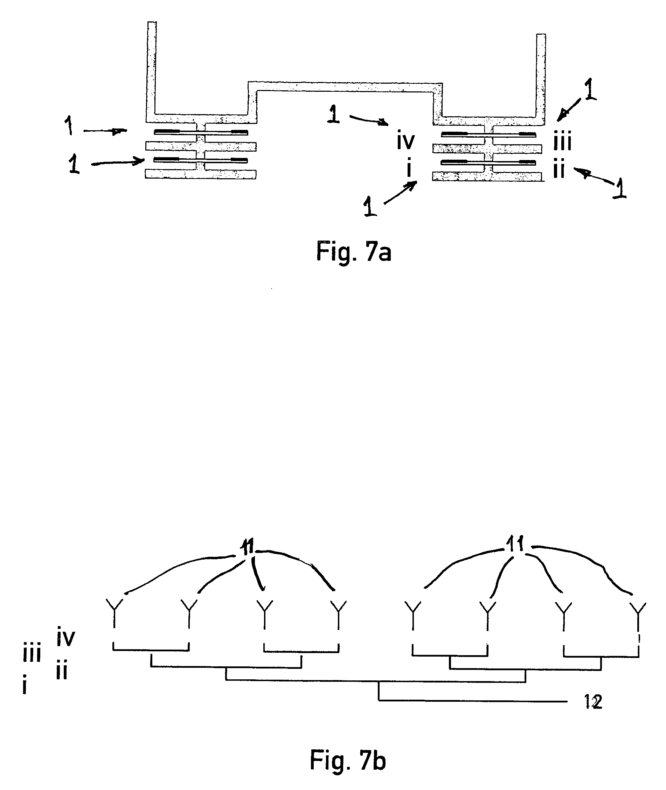

A system 10 as has been described above can, as an example, be put to use as an antenna feed, feeding antenna elements with signals. Thus, such a system could replace the usual coaxial cables in such an application. This could simply be accomplished by having a system of at least two transmission lines according to the invention connected to a corresponding at least two antenna elements 11. (Of course, the use of a singular transmission line of the invention to feed an antenna element is also possible, however that can be though of as just a singular transmission line rather than a system of transmission lines.) In comparison to a system using coaxial cables, this solution has the prospect of being both cheaper and allowing for a more rational production. Such a system in accordance with the invention is depicted in figs. 7a and 7b. Fig. 7a shows a system of transmission lines 1 connected to the back of an antenna reflector (no antenna radiating element is shown in fig. 7a). The different transmission lines 1 in fig. 7a are connected to each other in a way shown schematically in fig. 7b. An antenna feed signal can be supplied at the tail 12 in fig. 7b. This signal is then distributed to the different antenna element pairs 11 by the successive forking of a transmission line into new transmission lines. This can be studied in fig. 7b; each new fork level (or T-branch level) results in a doubling of the number of branches of the transmission lines. Each level is depicted with a roman numeral in fig. 7b and each such corresponding level is indicated in the schematic fig. 7a. In the end, the transmission lines are connected to an antenna element pair 11, as seen in fig. 7b.

The invention also comprises a method for production of a transmission line comprising the steps:
a) manufacturing a groove 2 defined by two parallel conducting walls 3 and a conducting floor 4 all electrically connected to each other, together forming a peripheral conductor of the transmission line, and
b) submersing a centre conductor 5, at least partly in the groove 2, such that the centre conductor 5 is isolated from the conducting walls 3 and the conducting floor 4 of the groove 2, distinguished in that in step b: submersing a centre conductor 5 that comprises at least one conductor on a side of a printed circuit board 6.

The manufacture of a groove 2 in step a) could be accomplished in many ways. For instance by milling in a solid body such as a metal body. Another alternative would be to create a metal profile by extrusion or folding of a metal sheet. A third alternative would be to connect different separate parts that together form the groove. It should be emphasised that any embodiment of the transmission line and the system described above, could be produced in a corresponding step in the method of the invention.

### Legend

- 1: Transmission line
- 2: Groove
- 3: Wall
- 4: Floor
- 5: Centre conductor
- 6: PCB
- 7: Reflector
- 8: Slidable dielectric
- 9: Conducting element
- 10: System
- 11: Antenna element pair
- 12: Tail

## Claims

1. Transmission line (1) comprising:
- an open groove (2) defined by two parallel conducting walls (3) and a conducting floor (4) all electrically connected to each other, together forming a peripheral conductor of the transmission line, and
- a centre conductor (5), at least partly submersed in the groove (2), the centre conductor (5) being isolated from the conducting walls (3) and the conducting floor (4) of the groove (2), and
- a printed circuit board (6), wherein the centre conductor (5) comprises at least one conductor formed on one side of the printed circuit board (6), the printed circuit board (6) is positioned in the groove (2) with its main surfaces in parallel with the two parallel conducting walls (3) of the groove (2), and a slidable dielectric (8) positioned in a space between the centre conductor (5) and at least one of the parallel conducting walls (3), the dielectric (8) being slidable in a longitudinal direction along the groove or, alternatively, in a direction in or out of the groove.

2. Transmission line (1) according to claim 1, wherein the centre conductor (5) comprises two conductors on two sides of the printed circuit board (6).

3. Transmission line (1) according to claim 1 or 2, wherein the centre conductor (5) is formed on the printed circuit board (6) by etching.

4. Transmission line (1) according to any of claims 1-3, wherein the groove (2) is defined by an aluminium profile.

5. Transmission line (1) according to any of claims 1-4, wherein at least a part of any of the walls (3) and the floor (4) defining the groove is a part of an antenna reflector (7).

6. System (10) comprising a plurality of transmission lines (1) according to any of claims 1-5, wherein at least two centre conductors (5) of the plurality of transmission lines are connected to each other with a conducting element (9) in order to provide for a dividing of a signal that can enter the system (10) on one of the plurality of transmission lines into at least one other transmission line.

7. System (10) according to claim 6, wherein at least two centre conductors are formed on a same printed circuit board (6).

8. System (10) according to claim 7, wherein the conducting element (9) is a conductor formed on the printed circuit board (6).

9. System (10) according to claim 6, wherein at least two centre conductors are on separate printed circuit boards (6) and that the conducting element is running either through one of the walls or through the floor of the groove of at least one of the transmission lines.

10. System (10) according to any of claims 6-9, wherein at least two transmission lines are connected to a corresponding at least two antenna elements (11).

## Patentansprüche

1. Übertragungsleitung (1), umfassend:
- eine offene Nut (2), durch zwei parallele leitende Wände (3) und einen leitenden Boden (4) definiert, die alle elektrisch miteinander verbunden sind, die zusammen einen peripheren Leiter der Übertragungsleitung bilden, und
- einen Mittelleiter (5), der zumindest teilweise in der Nut (2) eingetaucht ist, wobei der Mittelleiter (5) von den leitenden Wänden (3) und dem leitenden Boden (4) der Nut (2) isoliert ist, und
- eine Leiterplatte (6), wobei der Mittelleiter (5) mindestens einen auf einer Seite der Leiterplatte (6) ausgebildeten Leiter umfasst, wobei die Leiterplatte (6) in der Nut (2) mit ihren Hauptoberflächen parallel zu den beiden parallelen leitenden Wänden (3) der Nut (2) positioniert ist und ein gleitbares Dielektrikum (8) in einem Raum zwischen dem Mittelleiter (5) und mindestens einer der parallelen leitenden Wände (3) positioniert ist, wobei das Dielektrikum (8) in einer Längsrichtung entlang der Nut oder alternativ in einer Richtung in die Nut oder aus der Nut heraus gleiten kann.

2. Übertragungsleitung (1) nach Anspruch 1, wobei der Mittelleiter (5) zwei Leiter auf zwei Seiten der Leiterplatte (6) umfasst.

3. Übertragungsleitung (1) nach Anspruch 1 oder 2, wobei der Mittelleiter (5) durch Ätzen auf der Leiterplatte (6) ausgebildet wird.

4. Übertragungsleitung (1) nach einem der Ansprüche 1-3, wobei die Nut (2) durch ein Aluminiumprofil definiert ist.

5. Übertragungsleitung (1) nach einem der Ansprüche 1-4, wobei mindestens ein Teil eines beliebigen der Wände (3) und des Bodens (4), der die Nut definiert, ein Teil eines Antennenreflektors (7) ist.

6. System (10), umfassend mehrere Übertragungsleitungen (1) nach einem der Ansprüche 1-5, wobei mindestens zwei Mittelleiter (5) der mehreren Übertragungsleitungen mit einem leitenden Element (9) miteinander verbunden sind, um für eine Aufteilung eines Signals zu sorgen, die auf einer der mehreren Übertragungsleitungen in mindestens eine andere Übertragungsleitung in das System (10) eintreten kann.

7. System (10) nach Anspruch 6, wobei mindestes zwei Mittelleiter auf einer gleichen Leiterplatte (6) ausgebildet sind.

8. System (10) nach Anspruch 7, wobei das leitende Element (9) ein auf der Leiterplatte (6) ausgebildeter Leiter ist.

9. System (10) nach Anspruch 6, wobei mindestens zwei Mittelleiter sich auf separaten Leiterplatten (6) befinden, und dass das leitende Element entweder durch eine der Wände oder durch den Boden der Nut mindestens einer der Übertragungsleitungen verläuft.

10. System (10) nach einem der Ansprüche 6-9, wobei mindestens zwei Übertragungsleitungen mit mindestens zwei entsprechenden Antennenelementen (11) verbunden sind.

## Revendications

1. Ligne de transmission (1) comprenant :
- une rainure ouverte (2) définie par deux parois conductrices (3) parallèles et un plancher conducteur (4) tous reliés électriquement les uns aux autres, formant ensemble un conducteur périphérique de la ligne de transmission ; et
- un conducteur central (5), au moins en partie immergé dans la rainure (2), le conducteur central (5) étant isolé des parois conductrices (3) et du plancher conducteur (4) de la rainure (2) ; et
- une carte de circuit imprimé (6) dans laquelle le conducteur central (5) comprend au moins un conducteur formé sur une face de la carte de circuit imprimé (6) ; la carte de circuit imprimé (6) étant positionnée dans la rainure (2) avec ses surfaces principales en parallèle avec les deux parois conductrices (3) parallèles de la rainure (2) ; et
un diélectrique (8) pouvant coulisser étant positionné dans un espace situé entre le conducteur central (5) et au moins une des parois conductrices (3) parallèles, le diélectrique (8) pouvant coulisser dans une direction longitudinale le long de la rainure ou, alternativement, dans une direction entrant ou sortant de la rainure.

2. Ligne de transmission (1) selon la revendication 1, dans laquelle le conducteur central (5) comprend deux conducteurs sur deux faces de la carte de circuit imprimé (6).

3. Ligne de transmission (1) selon la revendication 1 ou 2, dans laquelle le conducteur central (5) est formé par gravure sur la carte de circuit imprimé (6).

4. Ligne de transmission (1) selon l'une quelconque des revendications 1 à 3, dans laquelle la rainure (2) est définie par un profilé en aluminium.

5. Ligne de transmission (1) selon l'une quelconque des revendications 1 à 4, dans laquelle au moins une partie de n'importe quels éléments parmi les parois (3) et le plancher (4) définissant la rainure est une partie d'un réflecteur d'antenne (7).

6. Système (10) comprenant une pluralité de lignes de transmission (1) selon l'une quelconque des revendications 1 à 5, dans lequel au moins deux conducteurs centraux (5) parmi la pluralité de lignes de transmission sont reliés l'un à l'autre avec un élément conducteur (9) afin de réaliser une division d'un signal pouvant entrer dans le système (10) sur une ligne parmi la pluralité de lignes de transmission, pour entrer dans au moins une autre ligne de transmission.

7. Système (10) selon la revendication 6, dans lequel au moins deux conducteurs centraux sont formés sur une même carte de circuit imprimé (6).

8. Système (10) selon la revendication 7, dans lequel l'élément conducteur (9) est un conducteur formé sur la carte de circuit imprimé (6).

9. Système (10) selon la revendication 6, dans lequel au moins deux conducteurs centraux sont sur des cartes de circuit imprimé (6) séparées et dans lequel l'élément conducteur passe soit à travers une des parois soit à travers le plancher de la rainure d'au moins un des lignes de transmission.

10. Système (10) selon l'une quelconque des revendications 6 à 9, dans lequel au moins deux lignes de transmission sont reliées à un élément correspondant parmi au moins deux éléments d'antenne (11).
